# EUROPÄISCHE PATENTSCHRIFT

(11) **EP 2 553 783 B1**
(45) Veröffentlichungstag und Bekanntmachung des Hinweises auf die Patenterteilung: **13.03.2019**
(21) Anmeldenummer: 11710767.2
(22) Anmeldetag: 23.03.2011
(51) Int. Cl.: H02B 1/56, H02B 1/28, H01H 9/04, H05K 7/20

(54) **EXPLOSIONSGESCHÜTZTES GEHÄUSE MIT ERWEITERTEM UMGEBUNGSTEMPERATURBEREICH**
EXPLOSION PROOF HOUSING HAVING AN EXPANDED AMBIENT TEMPERATURE RANGE
BOÎTIER ANTIDÉFLAGRANT AVEC UNE PLAGE DE TEMPÉRATURE AMBIANTE ÉLARGIE

(30) Priorität: 29.03.2010 DE 102010013313
(43) Veröffentlichungstag der Anmeldung: 06.02.2013
(73) Patentinhaber: R. Stahl Schaltgeräte GmbH, 74638 Waldenburg (DE)
(72) Erfinder: LIMBACHER, Bernd, 74523 Schwäbisch Hall (DE); HERMANN, Wolf, 74613 Öhringen (DE); POIDL, Jürgen, 74653 Kocherstetten (DE); RÜCKGAUER, Johannes, 74653 Nagelsberg (DE)
(74) Vertreter: Rüger Abel
(86) Internationale Anmeldenummer: PCT/EP2011/054489
(87) Internationale Veröffentlichungsnummer: WO 2011/124475

(56) Entgegenhaltungen:
- EP-A2- 0 036 384
- CN-U- 201 577 020
- CN-Y- 2 678 237
- DE-A1- 4 307 061
- DE-A1- 4 413 128
- DE-U- 1 895 088
- FR-A1- 2 807 285
- US-A1- 2004 008 483
- US-A1- 2007 285 889
- US-A1- 2010 288 467
- US-B1- 6 330 152

## Beschreibung

Gehäuse die elektrische Betriebsmittel beherbergen und in explosionsgefährdeten Atmosphären betrieben werden, müssen die Vorschriften des Explosionsschutzes erfüllen. Zu diesen Vorschriften gehört auch die Definition der maximalen und der minimalen Gehäusetemperatur. Die minimale Gehäusetemperatur wird festgelegt, weil sich mit sinkender Temperatur die Festigkeitseigenschaften des Materials des Gehäuses verändern. Unterhalb bestimmter
Gehäusetemperaturen beispielsweise unter -60° reicht die Festigkeit der Aluminiumgehäuse nicht mehr aus, um eventuellen Explosionen im Inneren des Gehäuses Stand zu halten.

Aus CN 2678237 Y ist ein explosionsgeschütztes Gehäuse bekannt, in dem ein Frequenzwandler angeordnet ist. Zur Kühlung des Frequenzwandlers ist ein kombiniertes Luft- und Wasserkühlsystem vorgesehen.

In DE 18 95 088 U ist ein explosionsgeschützter Trockenschrank beschrieben. Der Trockenschrank dient dazu, Gegenstände zur Trocknung in einem Nutzraum anzuordnen. Dieser Nutzraum ist über ein Heizelement im Inneren des Trockenschrankes beheizt. Über das Heizelement soll eine gleichmäßige Temperaturverteilung in dem Nutzraum des Trockenschrankes erreicht werden. Gegenüber der Gehäusewand sind das Heizelement und der Nutzraum des Trockenschranks durch eine Isolationsschicht isoliert.

US 6 330 152 B1 beschreibt einen Klimaschrank zum Testen der Temperaturunempfindlichkeit von elektronischen Komponenten.

DE 43 07 061 A1 beschreibt einen staubfrei gekapselten Schaltschrank, dessen Innentemperatur durch eine Kühleinrichtung begrenzt wird.

Mit sinkender Innentemperatur im Gehäuse steigt die Gasmenge innerhalb des Gehäuses. Die erhöhte Gasmenge erhöht den Gasdruck bei einer eventuellen Explosion im Inneren des Gehäuses und lässt das Gehäuse bersten.

Außerdem ist zu bedenken, dass die explosionsfähigen Stoffen ausgesetzten Oberflächen potentielle Zündquellen sind. Die von ihnen ausgehende Zündgefahr wird beeinflusst durch die Zündtemperatur des explosionsfähigen Stoffs und der Gehäusetemperatur an der Oberfläche. Die maximal zulässige Gehäusetemperatur an der Oberfläche wird in Abhängigkeit von der explosionsfähigen Umgebung, für die das Gehäuse ausgelegt ist, bestimmt. Unter dem funktionellen Aspekt sind die spezifizierten Einsatztemperaturen der Einbauten einzuhalten.

Somit ist die maximale Gehäusetemperatur weniger eine Frage des Gehäusematerials oder der Gasmenge als vielmehr eine Frage der Wärmeabfuhr von den elektrischen Betriebmittel im Inneren des Gehäuses durch die Gehäusewand hindurch nach außen. Soweit keine besonderen Kühlmaßnahmen vorgesehen sind, werden die elektrischen Betriebmittel im Inneren des Gehäuses nur durch die dort vorhandene Konvektion oder Wärmeleitung zu den Gehäusewänden hin gekühlt. Haben die Gehäusewände eine zu hohe Gehäusetemperatur besteht die Gefahr, dass die elektrischen Betriebmittel wärmer als zulässig werden. Sie könnten selbst überhitzen oder es könnte ein das Gehäuse oder die Bauteile umgebendes Gas, das zündfähig ist, gezündet werden.

Ausgehend hiervon ist es deswegen Aufgabe der Erfindung ein Gehäuse zu schaffen, das eine der Zündschutzarten erfüllt und einen entweder nach oben oder nach unten erweiterten Umgebungstemperaturbereich ermöglicht.

Diese Aufgabe wird erfindungsgemäß durch Gehäuse mit den Merkmalen des Anspruches 1 gelöst.

Wenn es darum geht den Umgebungstemperaturbereich nach oben zu erweitern, ist das Gehäuse mit einer Kühleinrichtung versehen. Mit Hilfe eines Thermofühlers wird die Gehäusetemperatur des Gehäuses erfasst. Der gemessene Wert wird einer Steuereinrichtung zugeführt, die sodann beim Erreichen einer kritischen Gehäusetemperatur die Kühleinrichtung aktiviert.

Dadurch wird sicher gestellt, dass auch unter ungünstigen Bedingungen, beispielsweise starker Sonneneinstrahlung, rechtzeitig die Gehäusetemperatur auf solchen Werten gehalten wird, die ein übermäßiges Erwärmen der elektrischen Betriebsmittel im Inneren des Gehäuses verhindern und das Einhalten der zulässigen Gehäusetemperaturen an der Oberfläche des Gehäuses gewährleisten. Die Kühleinrichtung braucht nicht ständig aktiv zu sein und verbraucht folglich Energie nur dann, wenn die Kühlung tatsächlich benötigt wird.

Wenn es hingegen darum geht den Umgebungstemperaturbereich nach unten zu erweitern, ist das Gehäuse mit einer Heizeinrichtung versehen, die für wenigstens eine der Gehäusewände wirksam ist. Auch hier wird wieder mit Hilfe einer Temperaturmesseinrichtung und einer Steuereinrichtung dafür gesorgt, dass die Heizeinrichtung nur dann aktiviert wird, wenn ein Unterschreiten der zulässigen Innentemperatur im Gehäuse oder Gehäusetemperatur oder der Einsatztemperatur der Einbauten zu befürchten ist.

Die thermischen Einrichtungen können mit den Gehäusewänden unmittelbar gekoppelt sein oder sich im Inneren des Gehäuses befinden, so dass sie über einen Luftspalt mit den Gehäusewänden zusammenwirken. Auch ist es denkbar, die Heiz- und die Kühleinrichtung miteinander zu verbinden, damit in Extrembereichen für das Gehäuse sowohl die obere als auch die untere zulässige Gehäusetemperatur erweitert wird.

Der Thermofühler kann in Form eines NTC-Widerstandes oder eines Strahlungspyrometers ausgeführt sein. Der Thermofühler oder Thermosensor ist erfindungsgemäß unmittelbar mit der Wand verbunden, damit kein Luftspalt dazwischen ist.

Die Heiz- oder Kühleinrichtung kann unmittelbar mit den Gehäusewänden gekoppelt sein. Sie kann sich dabei im Inneren des Gehäuses befinden oder auf dessen Außenseite.

Die Heiz- und/oder die Kühleinrichtung kann mit einem Wärmeübertragungsmedium arbeiten, das durch die Heiz- und/oder Kühleinrichtung hindurch zirkuliert.

Die Kühleinrichtung kann auch ein Peltierelement umfassen, das an einer Gehäusewand außen angebracht ist und zwar an einer Stelle, an der eine gute Wärmeabfuhr durch die umgebende Luft ermöglicht ist.

Eine Heizeinrichtung kann beispielsweise in Gestalt einer elektrischen Heizeinrichtung ausgeführt sein, mit Widerstandsheizdraht oder in Form einer Induktionsheizung, indem an den betreffenden Wänden eine ferromagnetische Platte befestigt ist, die über Wirbelstromverluste aufgeheizt wird.

Das Gehäuse kann in einer der möglichen Zündschutzarten ausgeführt sein. Zu diesen Zündschutzarten gehören druckfeste Kapselung, erhöhte Sicherheit, Sandkapselung, Ölkapselung, Überdruckkapselung und dergleichen.

Im Übrigen sind Weiterbildungen der Erfindung Gegenstand von Unteransprüchen.

Die nachfolgende Figurenbeschreibung erläutert Aspekte zum Verständnis der Erfindung. Weitere nicht beschriebene Details kann der Fachmann in der gewohnten Weise den Zeichnungen entnehmen, die insoweit die Figurenbeschreibung ergänzen. Es ist klar, dass eine Reihe von Abwandlungen und Kombinationen der einzelnen Ausführungsbeispiele möglich sind.

Die nachfolgenden Zeichnungen sind nicht unbedingt maßstäblich. Zur Veranschaulichung von Details können möglicherweise bestimmte Bereiche übertrieben groß dargestellt sein. Darüber hinaus sind die Zeichnungen plakativ vereinfacht und enthalten nicht jedes bei der praktischen Ausführung gegebenenfalls vorhandene Detail. Die Begriffe "oben" und "unten" bzw. "vorne" und "hinten" beziehen sich auf die normale Gebrauchslage bzw. die Terminologie bei explosionsgeschützten Gehäusen.

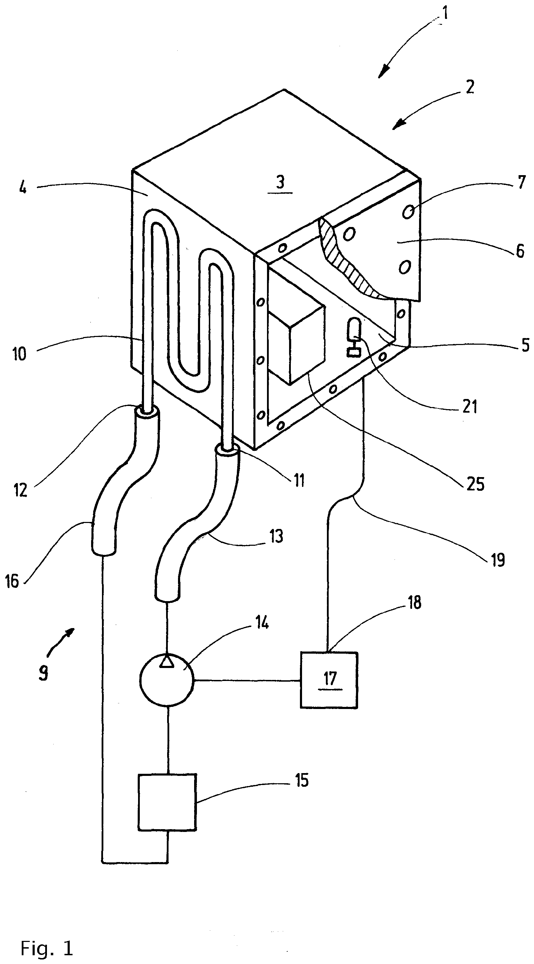

In der Zeichnung sind Ausführungsbeispiele des Gegenstandes der Erfindung dargestellt.

Die Figur zeigt eine Anordnung zum Temperieren eines Gehäuses. Zu der Anordnung gehört ein Gehäuse 1, das in einer Zündschutzart ausgeführt ist, die den Explosionsschutzvorschriften genügt. Das Gehäuse weist eine Zarge 2 mit insgesamt vier Seiten auf, von denen lediglich die Seiten 3 und 4 sichtbar sind. Die nach vorne zum Betrachter hin zeigende Öffnung 5 ist mit Hilfe eines Deckels 6 geschlossen. Der Deckel 6 ist mit Hilfe von nicht erkennbaren versenkten Schrauben an der Zarge 2 angeschraubt. Die Schrauben stecken in Flachsenkungen 7. Die Zarge 2 und der Deckel 6 bestehen aus Metall, beispielsweise Aluminiumdruckguss oder aus verschweißten Stahlplatten, die beispielsweise an dem die Öffnung 5 umgebenden Rand durch spangebende Verfahren geplant ist.

Ferner gehört zu der Anordnung eine Temperiersystem 9. Diese umfasst eine Rohrschlange 10, die an der nach links zum Betrachter zeigenden Wand 4 angebracht ist. Die Rohrschlange 10 sitzt mit geringem Wärmeübergang auf der Außenseite der Wand 4. Die Rohrschlange 10 kann beispielsweise auf die Gehäusewand 4 aufgelötet oder aufgeschweißt werden, um in jedem Falle einen sehr guten Wärmekontakt zur Wand herzustellen.

Die Rohrschlange 10 weist einen Einlassanschluss 11 sowie einen Auslassanschluss 12 auf. Der Einlassanschluss 11 ist über ein Schlauch- oder ein Rohrsystem 13 mit dem Ausgang einer Umwälzpumpe 14 verbunden, die ebenfalls zu dem Temperiersystem 9 gehört. Die Saugseite der Umwälzpumpe 14 ist mit einer Temperiereinrichtung 15 des Temperiersystems 9 versehen, die, wie sich aus der späteren Erläuterung ergibt, entweder als Heiz- oder als Kühleinrichtung ausgestaltet ist. Die Zulaufseite der Temperiereinrichtung 15 ist über einen weiteren Schlauch 16 mit dem Auslass 12 verbunden.
Der Betrieb der Pumpe 15 wird über eine Steuereinrichtung 17 gesteuert. Die Steuereinrichtung 17 liefert außerdem die Energie zum Betrieb der Pumpe 14. Die Steuereinrichtung 17 verfügt über einen Steuereingang 18, an den über eine Leitung 19 ein Thermofühler 21 angeschlossen ist, der sich im Inneren des Gehäuses 1 befindet.
Zur Erläuterung eines Aspektes der Erfindung sei zunächst einmal angenommen, das Gehäuse 1 ist in der Zündschutzart druckfeste Kapselung ausgeführt. Damit soll das Gehäuse verhindern, dass Zündfunken im Inneren des Gehäuses 1 zündfähige Gase, die sich in der Umgebung des Gehäuses 1 befinden, ebenfalls zünden können. Der Spalt zwischen der Zarge 2 und dem Deckel 6 ist deswegen als zünddurchschlagssicherer Spalt ausgeführt. Auch die Kabeldurchführung zum Anschluss des Thermofühlers 21 ist in der Zündschutzart druckfeste Kapselung gestaltet.
Ein zünddurchschlagssicherer Spalt ist nicht vollkommen dicht, vielmehr kann durch den Spalt ein Druckausgleich zur Außenatmosphäre stattfinden. Die Konsequenz hieraus ist, dass mit sinkender Innentemperatur im Gehäuse zunehmend Gas aus er Umgebung in den Innenraum des Gehäuses 1 gelangt. Für die Betrachtung des Gefährdungspotentials ist davon auszugehen, dass es sich hierbei um zündfähiges Gas handelt. Je größer nun die eingeschlossene Gasmenge ist, umso größer sind die Drücke die im Falle einer Zündung entstehen.

Um die Gasmenge zu reduzieren, wird die Temperatur des Gases innerhalb des Gehäuses 1 mit Hilfe des Thermofühlers 21 erfasst. Dieser meldet die Temperatur als elektrisches Signal an die Steuereinrichtung 17. Wenn die Innentemperatur in dem Gehäuse 1 unter einen vorbestimmten Wert sinkt, schaltet die Steuereinrichtung 17 die Umwälzpumpe 14 ein, die daraufhin Fluid durch die Rohrschlange 10 pumpt. Das Fluid wird in der Temperiereinrichtung 15 aufgeheizt und sorgt somit dafür, dass die Wand 4 der Zarge 2 ebenfalls aufgeheizt wird. Dadurch steigt die Gehäusetemperatur an den Gehäusewänden und die Gasmenge innerhalb des Gehäuses 1 wird entsprechend der Innentemperatur im Gehäuse vermindert. Das Gehäuse 1 wird somit in einem Temperaturbereich betrieben, für den es bemessen ist. Durch die Heizeinrichtung wird somit dafür gesorgt, dass das Gehäuse beispielsweise über die minimal zulässige Umgebungstemperatur von -30° noch im Bereich von -50° einsetzbar ist und die Zulassungsvorschriften erfüllt.

Es bedarf nicht weiter betont werden, dass das Abschalten der Umwälzpumpe 14 erfolgt, sobald der Thermofühler 21 einen hinreichenden Anstieg der Temperatur auf den erforderlichen Wert gemessen hat. Gleiches gilt auch für die Heizeinrichtung 15, die gegebenenfalls ebenfalls über die Steuereinrichtung 17 mit aktiviert oder deaktiviert wird.

Die oben gemachten Ausführungen für ein Gehäuse der Zündschutzart druckfeste Kapselung gelten sinngemäß auch für ein Gehäuse, in der Zündschutzart Sandkapselung.

Wenn das Gehäuse 1 in der Zündschutzart erhöhte Sicherheit ausgeführt ist, befinden sich im Inneren des Gehäuses entweder Einrichtungen, die von Haus aus die Zündschutzart erhöhte Sicherheit erfüllen, oder es können sich in dem Gehäuse wiederum andere Gehäuse befinden, die ihrerseits in der Zündschutzart druckfeste Kapselung ausgeführt sind. Ein solches Gehäuse ist bei 25 schematisch angedeutet. Auch dieses Gehäuse 25 darf nur in dem Umgebungstemperaturbereich betrieben werden, für den es zugelassen ist. Bei tieferen Temperaturen würde wiederum die Gasmenge zu groß werden und es würden im Explosionsfall dem Druckanstieg nicht ausreichend widerstehen. Um dies zu verhindern muss wiederum in der Umgebung für eine hinreichend hohe Temperatur gesorgt werden. Diese ausreichend hohe Temperatur wird wiederum mit Hilfe des Gehäuses 1 und dem Temperiersystem 9 erreicht. Sollte der Thermofühler 21 eine zu niedrige Umgebungstemperatur für das Gehäuse 25 ermitteln, wird, wie zuvor beschrieben, die Heizeinrichtung in Gang gesetzt. Auf entsprechende Temperaturen erwärmtes Fluid wird mit Hilfe der Umwälzpumpe 14 durch die Rohrschlange 10 gepumpt um das Gehäuse 1 zu erwärmen.

Im beschriebenen Fall wirkt das Gehäuse 1 aus der Sicht des explosionsgeschützten Gehäuses 25 wie eine Klimakammer, die die Vorschriften des Explosionsschutzes erfüllt.

Die Wirkweise der beiden Anwendungsfälle unterscheiden sich geringfügig voneinander, jedoch ist der Aufbau in beiden Fällen prinzipiell der Gleiche. Im Falle des Gehäuses 1 in der Ausführung druckfeste Kapselung ist es von Vorteil, wenn die Rohrschlange 10 auf der Außenseite des Gehäuses angebracht ist. Dadurch werden die Durchführung der Zündschutzart druckfeste Kapselung vermieden.

Mit der beschriebenen Anordnung ist es nicht nur möglich den Temperaturbereich des Gehäuses 1 nach unten zu erweitern sondern auch nach oben. In diesem Falle arbeitet das Temperiersystem 9 als Kühleinrichtung und kühlt das durch die Rohrschlange 10 zirkulierende Fluid entsprechend herunter, um Wärme von dem Gehäuse 1 abzuführen. Die Aktivierung des Kühlsystems erfolgt wiederum in Abhängigkeit von der Temperatur, die durch den Thermofühler 21 erfasst wird. Steigt die Temperatur innerhalb des Gehäuses 1 über einen zulässigen Grenzwert, werden die Umwälzpumpe 14 und die Kühleinrichtung 15 aktiviert. Das Gehäuse 1 wird gekühlt und damit wird gleichzeitig Wärme aus dem Inneren des Gehäuses 1 abgeführt. Die Gehäusetemperatur an der Oberfläche wird somit innerhalb vorgegebener Grenzen gehalten.

Solche ungünstigen Übertemperaturen können beispielsweise entstehen, wenn das Gehäuse einer besonderen Sonneneinstrahlung ausgesetzt ist. Ähnliche Bedingungen können auch auftreten, wenn die Geräte, die in dem klimatisierten Ex-e-Gehäuse enthalten sind, zufälligerweise gleichzeitig sehr viel Verlustwärme erzeugen.

Im Falle eines Gehäuses in der Zündschutzart erhöhte Sicherheit kann die Rohrschlange 10 auch innerhalb des Gehäuses 1 ohne weiteres angeordnet werden, weil keine besonderen Durchführungen erforderlich sind.

Wenn es nur darum geht zu heizen, wäre es auch denkbar das Gehäuse induktiv zu heizen, ähnlich einem Induktionsherd.

Mit der beschriebenen Anordnung wird somit ein Verfahren ermöglicht, um den Temperaturbereich nach oben und/oder nach unten zu erweitern. Zu diesem Zweck wird ein Gehäuse bereit gestellt, dass mit einem Temperiersystem versehen ist. Abhängig von der Innentemperatur im Gehäuse wird das Temperiersystem im Sinne eines Kühlens oder eines Heizens in Gang gesetzt. Durch Heizen wird der Umgebungstemperaturbereich nach unten erweitert, indem durch Heizen die Menge an explosionsfähigem Gas in dem Gehäuse auf einem niedrigen Wert gehalten wird. Im Falle des Kühlens wird eine klimatisierte Umgebung für im Gehäuse befindliche und Verlustwärme erzeugenden Teile erreicht. Es können die zulässigen Gehäusetemperaturen an der Oberfläche des Gehäuses 1 bzw. die zulässigen Oberflächentemperaturen der Einbauten eingehalten werden. Die Kühlung ist nicht auf ein Gehäuse der Zündschutzarte erhöhte Sicherheit beschränkt, dieser Gehäusetyp ist nur beispielhaft erwähnt. Gehäuse in den Zündschutzarten druckfest Kapselung, Sandkapselung, Ölkapselung oder Überdruckkapselung sind ebenfalls möglich

Der Thermofühler 21 ist mit einer der Gehäusewänden thermisch fest gekoppelt, um primär die Gehäusetemperatur zu erfassen.

Ein Gehäuse, das in einer Zündschutzart gemäß dem Explosionsschutz ausgeführt ist, ist mit einer Temperiereinrichtung versehen. Die Temperiereinrichtung besteht aus einer Rohrschlange, die mit wenigstens einer der Wände thermisch gut gekoppelt ist. Über eine Umwälzpumpe wird gegebenenfalls Temperierfluid durch die Rohrschlange geleitet um, je nach Anwendungsfall, die Gehäusetemperatur des Gehäuses zu erhöhen oder abzusenken.

## Patentansprüche

1. Anordnung mit einem explosionsgeschützten Gehäuse (1), das Gehäusewände (3,4) aufweist, und mit einem Temperiersystem (9) für das Gehäuse (1) zu dem gehören:
- wenigstens einem Thermofühler (21) zum Erfassen der Gehäusetemperatur, wobei der Thermofühler (21) unmittelbar thermisch mit einer der Gehäusewände (3,4) gekoppelt ist,
- eine Kühlanordnung (10,14,15)
- eine Heizanordnung (10,14,15) und
- eine Steuereinrichtung (17) zum wahlweisen Aktivieren oder Abschalten der Kühlanordnung (10,14,15) und der Heizanordnung (10,14,15),
wobei die Steuereinrichtung (17) dazu eingerichtet ist, beim Erreichen einer kritischen Gehäusetemperatur die Kühlanordnung (10,14,15) zu aktivieren,
und wobei die Steuereinrichtung (17) dazu eingerichtet ist, die Heizanordnung (10,14,15) nur dann zu aktivieren, wenn ein Unterschreiten der zulässigen Innentemperatur im Gehäuse (1) oder Gehäusetemperatur oder der Einsatztemperatur der Einbauten zu erwarten ist.

2. Anordnung nach Anspruch 1, **dadurch gekennzeichnet, dass** die Heiz- oder die Kühlanordnung (10) des Temperiersystems (9) ohne Luftspalt mit wenigstens einer der Gehäusewände (4) gekoppelt ist oder sich im Gehäuseinneren befindet.

3. Anordnung nach Anspruch 1, **dadurch gekennzeichnet, dass** die Heizanordnung (10) des Temperiersystems (9) sich im Gehäuseinneren befindet und von den Gehäusewänden (3,4) getrennt ist.

4. Anordnung nach Anspruch 1, **dadurch gekennzeichnet, dass** die Heiz- oder die Kühlanordnung (10) mit einem Wärmeübertragungsfluid arbeitet, das über rohrförmige Leitungen (13,16) zu- und abgeführt wird.

5. Anordnung nach Anspruch 1, **dadurch gekennzeichnet, dass** die Heizanordnung (10) eine elektrische Heizschlage (10) oder eine Induktionsheizung umfasst.

6. Anordnung nach Anspruch 1, **dadurch gekennzeichnet, dass** das Gehäuse (1) in einer der Zündschutzarten ausgeführt ist, wie druckfeste Kapselung, erhöhte Sicherheit, Sandkapselung oder Ölkapselung.

7. Anordnung nach Anspruch 1, **dadurch gekennzeichnet, dass** sie einen Wärmetauscher (10), der mit dem Gehäuse gekuppelt ist, aufweist.

8. Verfahren zum Erweitern des Temperaturbereiches eines explosionsgeschützten Gehäuses (1), das Bestandteil einer Anordnung nach einem der vorhergehenden Ansprüche ist, wobei das Verfahren umfasst:
- Regelung/Steuerung der Heizanordnung (10,14,15) und der Kühlanordnung (10,14,15) in Abhängigkeit von der Gehäusetemperatur, die durch den wenigstens einen Thermofühler (21) an der Gehäusewand (3,4) des explosionsgeschützten Gehäuse (1) gemessen wird, durch die Steuereinrichtung derart, dass die Steuereinrichtung (17) beim Erreichen einer kritischen Gehäusetemperatur die Kühlanordnung (10,14,15) aktiviert, und dass die Steuereinrichtung (17) die Heizanordnung (10,14,15) nur aktiviert, wenn ein Unterschreiten der zulässigen Innentemperatur im Gehäuse (1) oder Gehäusetemperatur oder der Einsatztemperatur der Einbauten zu erwarten ist.

## Claims

1. Arrangement with an explosion-proof housing (1) having housing walls (3, 4), and with a tempering system (9) for the housing (1) which comprises:
- at least one thermosensor (21) for detecting the housing temperature, wherein the thermosensor (21) is directly thermally coupled to one of the housing walls (3, 4),
- a cooling arrangement (10, 14, 15),
- a heating arrangement (10, 14, 15), and
- a control device (17) for optional activation or deactivation of the cooling arrangement (10, 14, 15) and of the heating arrangement (10, 14, 15),
wherein the control device (17) is configured to activate the cooling arrangement (10, 14, 15) when a critical housing temperature is reached,
and wherein the control device (17) is configured to activate the heating arrangement (10, 14, 15) only when the temperature is expected to fall below the permitted interior temperature in the housing (1) or the housing temperature or the usage temperature of the fittings.

2. Arrangement according to claim 1, **characterized in that** the heating or cooling arrangement (10) of the tempering system (9) is coupled to at least one of the housing walls (4) or is situated inside the housing interior without an air gap.

3. Arrangement according to claim 1, **characterized in that** the heating arrangement (10) of the tempering system (9) is situated in the housing interior and is separated from the housing walls (3, 4).

4. Arrangement according to claim 1, **characterized in that** the heating or cooling arrangement (10) works with a heat transfer fluid which is supplied and discharged via tubular lines (13, 16).

5. Arrangement according to claim 1, **characterized in that** the heating arrangement (10) comprises an electric heating coil (10) or an induction heater.

6. Arrangement according to claim 1, **characterized in that** the housing (1) is constructed in one of the explosion-proof designs such as pressure-resistant encapsulation, increased safety, sand encapsulation or oil encapsulation.

7. Arrangement according to claim 1, **characterized in that** it comprises a heat exchanger (10) which is coupled to the housing.

8. Method for widening the temperature range of an explosion-proof housing (1) which is part of an arrangement according to any of the preceding claims, wherein the method comprises:
- regulation/control of the heating arrangement (10, 14, 15) and of the cooling arrangement (10, 14, 15) by the control device, depending on the housing temperature which is measured by the at least one thermosensor (21) on the housing wall (3, 4) of the explosion-proof housing (1), such that the control device (17) activates the cooling arrangement (10, 14, 15) when a critical housing temperature is reached, and the control device (17) activates the heating arrangement (10, 14, 15) only when the temperature is expected to fall below the permitted interior temperature in the housing (1) or the housing temperature or the usage temperature of the fittings.

## Revendications

1. Dispositif comprenant un boîtier antidéflagrant (1) qui présente des parois de boîtier (3, 4), et comprenant un système de régulation de température (9) pour le boîtier (1), qui comporte :
- au moins un capteur thermique (21) destiné à recueillir la température du boîtier, sachant que le capteur thermique (21) est couplé directement, sur le plan thermique, à l'une des parois de boîtier (3, 4),
- un dispositif de refroidissement (10, 14, 15),
- un dispositif de chauffage (10, 14, 15) et
- un dispositif de commande (17) destiné à activer ou à couper au choix le dispositif de refroidissement (10, 14, 15) et le dispositif de chauffage (10, 14, 15),
le dispositif de commande (7) étant conçu pour activer le dispositif de refroidissement (10, 14, 15) lorsqu'une température de boîtier critique est atteinte,
et le dispositif de commande (17) étant conçu pour activer le dispositif de chauffage (10, 14, 15) uniquement lorsqu'il faut s'attendre à ce que la température passe en dessous de la température intérieure admissible du boîtier (1) ou de la température de boîtier ou de la température d'utilisation des éléments intégrés.

2. Dispositif selon la revendication 1, **caractérisé en ce que** le dispositif de chauffage ou de refroidissement (10) du système de régulation de température (9) est couplé sans interstice à au moins l'une des parois de boîtier (4) ou se trouve à l'intérieur du boîtier.

3. Dispositif selon la revendication 1, **caractérisé en ce que** le dispositif de chauffage (10) du système de régulation de température (9) se trouve à l'intérieur du boîtier et est séparé des parois de boîtier (3, 4).

4. Dispositif selon la revendication 1, **caractérisé en ce que** le dispositif de chauffage ou de refroidissement (10) fonctionne avec un fluide caloporteur qui est amené et évacué par l'intermédiaire de conduites (13, 16) tubulaires.

5. Dispositif selon la revendication 1, **caractérisé en ce que** le dispositif de chauffage (10) comprend un serpentin de chauffage (10) électrique ou un chauffage par induction.

6. Dispositif selon la revendication 1, **caractérisé en ce que** le boîtier (1) est réalisé selon l'un des types de protection antidéflagrante, à savoir une enveloppe antidéflagrante, à sécurité accrue, à remplissage pulvérulent ou à immersion dans l'huile.

7. Dispositif selon la revendication 1, **caractérisé en ce qu'**il présente un échangeur de chaleur (10) qui est couplé au boîtier.

8. Procédé pour élargir la plage de température d'un boîtier antidéflagrant (1) qui fait partie d'un dispositif selon l'une des revendications précédentes, le procédé comprenant :
- la régulation/commande du dispositif de chauffage (10, 14, 15) et du dispositif de refroidissement (10, 14, 15), en fonction de la température du boîtier qui est mesurée par le capteur thermique (21), au nombre d'au moins un, sur la paroi de boîtier (3, 4) du boîtier antidéflagrant (1), par le dispositif de commande, de manière à ce que, lorsqu'une température de boîtier critique est atteinte, le dispositif de commande (17) active le dispositif de refroidissement (10, 14, 15), et de manière à ce que le dispositif de commande (17) active le dispositif de chauffage (10, 14, 15) uniquement lorsqu'il faut s'attendre à ce que la température passe en dessous de la température intérieure admissible du boîtier (1) ou de la température de boîtier ou de la température d'utilisation des éléments intégrés.
